# EUROPEAN PATENT SPECIFICATION

(11) **EP 4 476 764 B1**
(45) Date of publication and mention of the grant of the patent: **27.08.2025**
(21) Application number: 23702087.0
(22) Date of filing: 24.01.2023
(51) Int. Cl.: H01L 21/74, H01L 21/768, H01L 23/48, H01L 23/528, H01L 23/535, H01L 21/762

(54) **SEMICONDUCTOR STRUCTURE WITH A BURIED POWER RAIL**
HALBLEITERSTRUKTUR MIT VERGRABENER STROMSCHIENE
STRUCTURE SEMI-CONDUCTRICE AVEC RAIL D'ALIMENTATION ENFOUI

(30) Priority: 09.02.2022 US 202217650385
(43) Date of publication of application: 18.12.2024
(73) Proprietor: International Business Machines Corporation, Armonk, New York 10504 (US)
(72) Inventor: CHOI, Kisik, Albany, New York 12203-3654 (US); XIE, Ruilong, Albany, New York 12203-3654 (US); LIE, Fee Li, Albany, New York 12203-3654 (US); GHOSH, Somnath, Albany, New York 12203-3654 (US); STANDAERT, Theodorus, Albany, New York 12203-3654 (US)
(74) Representative: IBM United Kingdom Limited
(86) International application number: PCT/EP2023/051654
(87) International publication number: WO 2023/151939

(56) References cited:
- JP-A- 2005 032 839
- US-A1- 2020 135 634
- US-A1- 2021 028 112

## Description

### FIELD OF THE INVENTION

The present application relates to a semiconductor structure having a buried power rail and method of manufacturing the same.

### BACKGROUND

With the continuous pursuit for the reduction in size of semiconductor circuitry, it becomes increasingly difficult to physically align semiconductor devices in and/or at various integration levels. One such example includes the integration of buried power rails in a semiconductor substrate.

At current transistor node level, the critical dimension (CD) of buried power rail has become extremely small. In a process of forming nano through-silicon-via to land on the buried power rail, a bad or poor CD or overlay control may cause the nano through-silicon-via to be shorted to the substrate which normally directly surrounds the buried power rails. US20210028112A1 describes a semiconductor device includes a substrate having a first surface and a second surface opposite to each other, and having an active region located on the first surface and defined by a first isolation region; a plurality of active fins arranged on the active region, extending in a first direction, and defined by a second isolation region having a second depth smaller than a first depth of the first isolation region; a buried conductive wiring in a trench adjacent to the plurality of active fins, and extending in a direction of the trench; a filling insulation portion in the trench, and having the buried conductive wiring therein; an interlayer insulation layer on the first and second isolation regions and on the buried conductive wiring; a contact structure penetrating the interlayer insulation layer, and contacting the buried conductive wiring; and a conductive through structure extending through the substrate from the second surface to the trench, and contacting the buried conductive wiring. JP2005032839A describes a semiconductor substrate, transistors, arranged in the vicinity of the surface of the semiconductor substrate, insulation layers for isolating the transistors, and lower power supply lines and an upper power supply line buried in the insulation layers for isolation.

### SUMMARY

According to an aspect of the present invention, there is provided a semiconductor structure. The semiconductor structure includes a substrate layer; and a buried power rail (BPR) embedded in the substrate layer, wherein the BPR is isolated from the substrate layer by an enlarged deep shallow-trench-isolation (STI) region. The enlarged deep STI region has a first width at near a top thereof and a second width at near a middle portion thereof, with the second width being larger than the first width.

Preferably, the present invention provides a semiconductor structure further including a nano through-silicon via (nTSV), with a bottom portion of the nTSV contacting a bottom portion of the BPR, where the bottom portion of the nTSV is fully surrounded by the enlarged deep STI region.

Preferably, the present invention provides a semiconductor structure, wherein the nTSV is embedded in the substrate layer and sidewalls of the TSV are fully surrounded by and isolated from the substrate layer by the enlarged deep STI region.

According to another aspect of the present invention, there is provided a method of forming a semiconductor structure. In one embodiment, the method includes providing a semiconductor substrate; forming first recesses in the semiconductor substrate; deepening and laterally widening the first recesses to form enlarged deep STI regions; filling the enlarged deep STI regions with a dielectric material; and forming at least one buried power rail (BPR) inside the dielectric material in the enlarged deep STI regions.

Preferably, the present invention provides a method further including flipping the semiconductor substrate upside down and forming a nano through-silicon via (nTSV) through at least a portion of the semiconductor substrate, wherein the nTSV contacts the at least one BPR.

Preferably, the present invention provides a method, wherein forming the nTSV further includes thinning down the semiconductor substrate to create a substrate layer and depositing an inter-level-dielectric (ILD) layer on top of the substrate layer.

Preferably, the present invention provides a method, wherein forming the nTSV further includes forming an nTSV opening through the ILD layer and the substrate layer to expose a bottom portion of the at least one BPR, via a patterning process, and filling the nTSV opening with one or more conductive materials to form the nTSV.

### BRIEF DESCRIPTION OF THE DRAWINGS

The present invention will be understood and appreciated more fully from the following detailed description of embodiments of present invention, taken in conjunction with accompanying drawings of which:
FIGS. 1-14 are demonstrative illustrations of cross-sectional views of a semiconductor structure during a process of a method of manufacturing thereof according to embodiments of present invention; and
FIG. 15 is a demonstrative illustration of a flow-chart of a method of manufacturing a semiconductor structure according to embodiments of present invention.

It will be appreciated that for simplicity and clarity purpose, elements shown in the drawings have not necessarily been drawn to scale. Further, and if applicable, in various functional block diagrams, two connected devices and/or elements may not necessarily be illustrated as being connected. In some other instances, grouping of certain elements in a functional block diagram may be solely for the purpose of description and may not necessarily imply that they are in a single physical entity or they are embodied in a single physical entity.

### DETAILED DESCRIPTION OF PREFERRED EMBODIMENTS

In the below detailed description and the accompanying drawings, it is to be understood that various layers, structures, and regions shown in the drawings are both demonstrative and schematic illustrations that are not drawn to scale. In addition, for the ease of explanation, one or more layers, structures, and regions of a type commonly used to form semiconductor devices or structures may not be explicitly shown in a given drawing. This does not imply that any layers, structures, and regions not explicitly shown are omitted from the actual semiconductor structures. With respect to semiconductor processing steps, it is to be emphasized that the descriptions provided herein are not intended to encompass all of the processing steps that may be required to form a functional semiconductor integrated circuit device. Rather, certain processing steps that are commonly used in forming semiconductor devices, such as, for example, wet cleaning and annealing steps, are purposefully not described herein for economy of description.

Moreover, the same or similar reference numbers are used throughout the drawings to denote the same or similar features, elements, or structures, and thus, a detailed explanation of the same or similar features, elements, or structures may not be repeated for each of the drawings. It is to be understood that the terms "about" or "substantially" as used herein with regard to thicknesses, widths, percentages, ranges, etc., are meant to denote being close or approximate to, but not exactly. For example, the term "about" or "substantially" as used herein implies that a small margin of error may be present, such as 1% or less than the stated amount. Likewise, the terms "on", "over", or "on top of" that are used herein to describe a positional relationship between two layers or structures are intended to be broadly construed and should not be interpreted as precluding the presence of one or more intervening layers or structures.

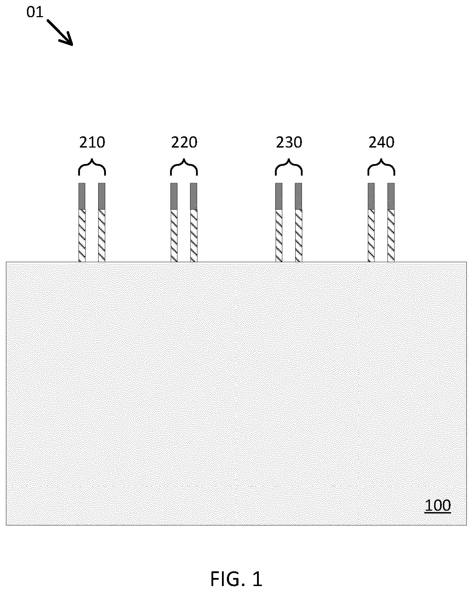

FIG. 1 is a demonstrative illustration of cross-sectional view of a semiconductor structure during a process of a method of manufacturing thereof according to one embodiment of present invention. More specifically, FIG. 1 illustrates a semiconductor structure 01 that includes a semiconductor substrate 100, and a plurality of sets of fins on top of semiconductor substrate 100. Semiconductor substrate 100 may be a bulk silicon (Si) substrate, a bulk germanium (Ge) substrate, a silicon-on-insulator (SOI) substrate, a silicon-germanium-on-insulator (SiGeOI) substrate, or any other suitable substrates.

The plurality of sets of fins may include multiple sets of fins and in this application a set of fins may include one or more fins. A set of fins may be created to make one type of field-effect-transistors (FETs) such as, for example, a p-type FET or an n-type FET. Hereinafter, a set of fins may be referred to a fin-set, and a set of fins that is created to make a p-type FET may be referred to as a PFET fin-set and a set of fins that is created to make an n-type FET may be referred to as an NFET fin-set.

As is illustrated in FIG. 1, semiconductor structure 01 may include a first fin-set 210, a second fin-set 220, a third fin-set 230, and a fourth fin-set 240. According to an embodiment, first fin-set 210 may be an NFET fin-set, second fin-set 220 may be a PFET fin-set, third fin-set 230 may be a PFET fin-set, and fourth fin-set 240 may be an NFET fin-set. Although not illustrated in FIG. 1, it is further assumed here that there may be an NFET fin-set to the left of first fin-set 210 and an NFET fin-set to the right of fourth fin-set 240 as well.

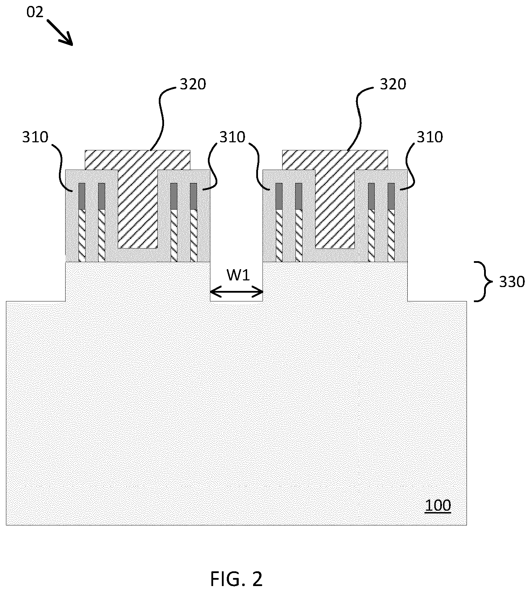

FIG. 2 is a demonstrative illustration of cross-sectional view of a semiconductor structure during a process of a method of manufacturing thereof according to one embodiment of present invention. More specifically, FIG. 2 illustrates a semiconductor structure 02 after forming a fin protecting liner 310 such as, for example, an oxide liner covering first, second, third, and fourth fin-set 210, 220, 230, and 240. In one embodiment, liner 310 may be a conformal liner and gaps between fins within a fin-set may be filled up by liner 310. The embodiment also includes applying a mask layer 320, such as an organic planarization layer (OPL), to cover and protect spaces between fin-sets for different types of FETs, while leave spaces open or uncovered between fin-sets for the same type of FETs. For example, the embodiment may include applying mask layer 320 to cover and protect spaces between first fin-set 210 and second fin-set 220 and between third fin-set 230 and fourth fin-set 240 and leave the space between second fin-set 220 and third fin-set 230, the space left to first fin-set 210, and the space right to fourth fin-set 240, uncovered. The embodiment further includes etching semiconductor substrate 100 to create a first recesses 330. First recesses 330 may be etched to have a depth around 20 to 80nm such that sufficient areas directly underneath fin-sets may be preserved for the formation and functioning of transistors, and not be affected by later process of forming buried power rails. First recesses 330 may have a first width W1.

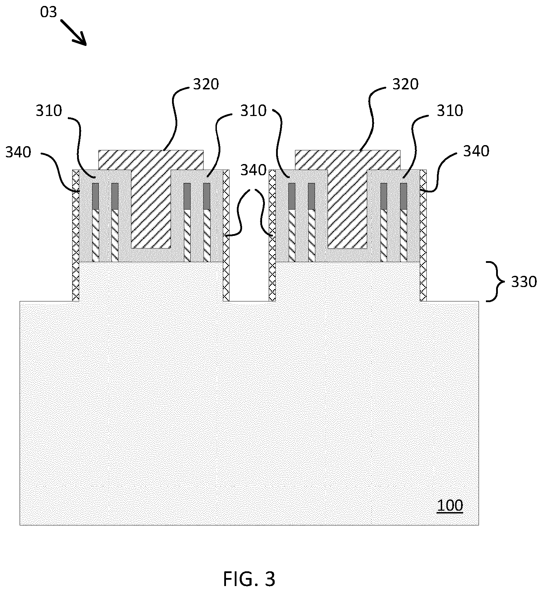

FIG. 3 is a demonstrative illustration of cross-sectional view of a semiconductor structure during a process of a method of manufacturing thereof according to one embodiment of present invention. More specifically, FIG. 3 illustrates a semiconductor structure 03 and one embodiment of the method includes forming additional liners 340 next to sidewalls of first recesses 330, thereby protecting the sidewalls of first recesses 330 from subsequent etching process. Liners 340 may be, for example, low temperature silicon-nitride (SiN) liner. However embodiment of present invention is not limited in this aspect and other materials of liners may be used as well.

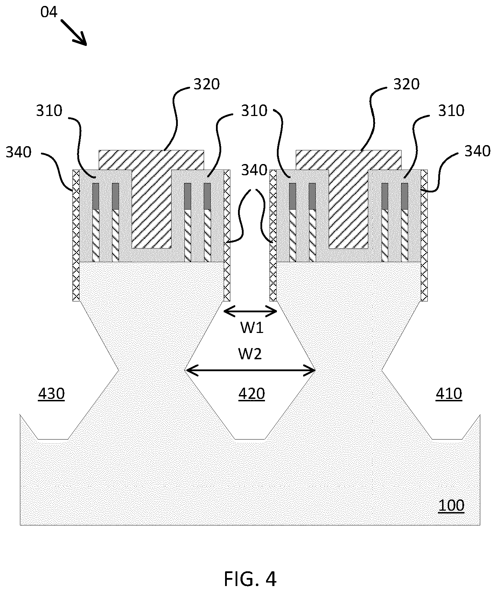

FIG. 4 is a demonstrative illustration of cross-sectional view of a semiconductor structure during a process of a method of manufacturing thereof according to one embodiment of present invention. More specifically, FIG. 4 illustrates a semiconductor structure 04 and one embodiment of the method includes performing etching further into semiconductor substrate 100 to deepen and widen first recesses 330 to create enlarged openings 410, 420, and 430 for forming enlarged deep STI regions in a later stage. For example, performing etching may include not only etching deep into semiconductor substrate 100 but also widening the etching in a horizontal direction, from the first width W1 of first recesses 330 (less the thickness of liner 340) to a second width W2 of enlarged openings 410, 420, and 430 with W2 being larger than W1, such that enlarged deep STI regions may be formed later. In one embodiment, anisotropic dry etching may be performed using, for example, HBr, Cl₂, He, followed with an isotropic wet etch with tetramethylammonium hydroxide (TMAH) to form the openings, and based on the type of etchants used and crystalline orientation of semiconductor substrate 100, enlarged openings 410, 420, and 430 may be in a sigma shape, in a diamond shape, or in a hexagon shape. The horizontal widening may go beyond liners 340 into regions underneath the fin-sets such as, for example, underneath second fin-set 220 and third fin-set 230. The enlarged openings 410, 420, and 430 may have the second width W2 at near the middle portion thereof larger than the first width W1 at near the top thereof that is near the top of semiconductor substrate 100.

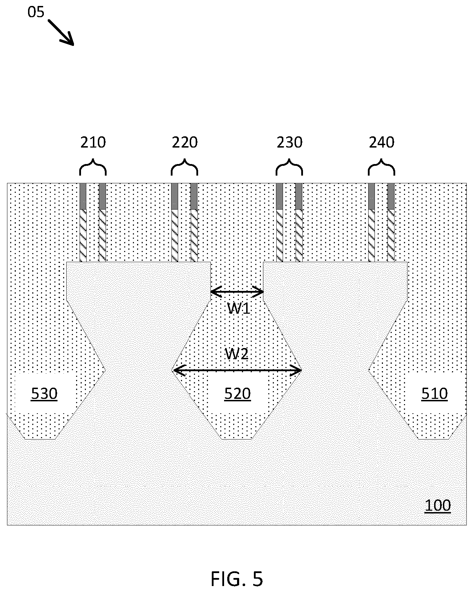

FIG. 5 is a demonstrative illustration of cross-sectional view of a semiconductor structure during a process of a method of manufacturing thereof according to one embodiment of present invention. More specifically, FIG. 5 illustrates a semiconductor structure 05 and one embodiment of the method includes selectively removing liners 340 that cover the sidewalls of first recesses 330, removing mask layer 320 between first fin-set 210 and second fin-set 220 and between third fin-set 230 and fourth fin-set 240, and removing liners 310 that cover first, second, third, and fourth fin-set 210, 220, 230, and 240 based on etch selectivity of respective materials to used etchants. The embodiment further includes subsequently filling enlarged openings 410, 420, and 430 with a dielectric material such as, for example, flowable oxide to create enlarged deep STI regions 510, 520, and 530. The flowable oxide may be deposited through a chemical vapor deposition (CVD) process, followed by a steam annealing process, to fill the re-entrant shape of the openings. In doing so, enlarged deep STI regions 510, 520, and 530 may have a first width W1 at near a top thereof and a second width at near the middle portion thereof and the second width W2 is larger than the first width W1.

Here, it is to be noted that other suitable dielectric materials, in addition to flowable oxide, may be used as well in forming the enlarged deep STI regions 510, 520, and 530. The dielectric material may be filled into the enlarged openings 410, 420, and 430, in spaces between the sidewalls of first recesses 330 previously covered by liners 340, and in spaces between and above first fin-set 210, second fin-set 220, third fin-set 230, and fourth fin-set 240. Embodiment then applies a chemical-mechanic-polishing (CMP) process to remove excessive dielectric material above the fins to polish down, for example, to the top of the fin hardmask.

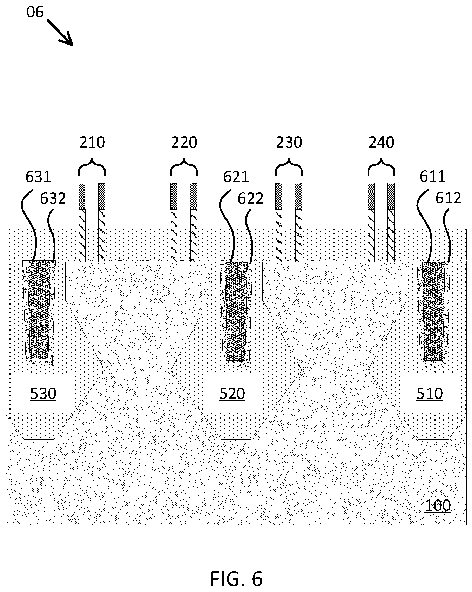

FIG. 6 is a demonstrative illustration of cross-sectional view of a semiconductor structure during a process of a method of manufacturing thereof according to one embodiment of present invention. More specifically, FIG. 6 illustrates a semiconductor structure 06 and one embodiment of the method includes forming buried power rail trenches, filling the buried power rail trenches with metals, recessing the buried power rail metals, overfilling the recess with a dielectric, planarizing the dielectric, and recessing the dielectric to reveal the fins with buried power rail still being covered by the dielectric.

More specifically, using lithographic patterning process, buried power rail trenches may be made inside enlarged deep STI regions 510, 520, and 530 and the trenches may be subsequently filled with one or more conductive materials, such as tungsten (W), cobalt (Co), ruthenium (Ru), and/or copper (Cu) (with a thin adhesive metal liner, such as TiN), to form buried power rails 611, 621, and 631. According to embodiments of present invention, the trenches (for forming buried power rails) may be created entirely inside enlarged deep STI regions 510, 520, and 530 and there is no part of the trenches that open directly to semiconductor substrate 100. Thereafter, a dielectric liner such as, for example, a SiN liner may be optionally formed inside the trenches first before one or more conductive materials are used to fill up the openings to form buried power rails. For example, liners 612, 622, 632 may be formed lining the bottoms and sidewalls of the trenches and then metals, such as W, Co, Ru, and/or Cu with a thin adhesive metal liner such as TiN, may be used to fill the remaining trenches to form buried power rails 611, 621, and 631. However, since buried power rails 611, 621, and 631 are now surrounded by dielectric materials of enlarged deep STI regions 510, 520, and 530, liners 612, 622, and 632 may not be necessary. After the metal fill, the metals may be recessed, followed by dielectric overfill, planarization of the dielectric, and recess of the dielectric to reveal the active fins for further device fabrication.

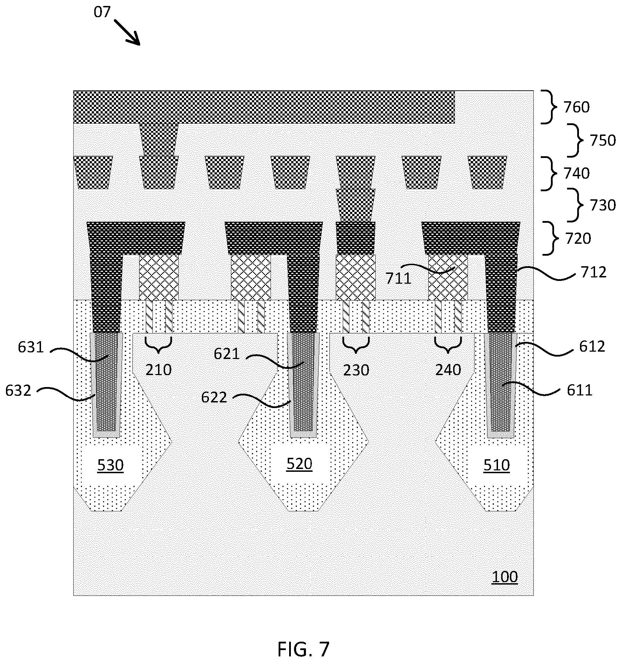

FIG. 7 is a demonstrative illustration of cross-sectional view of a semiconductor structure during a process of a method of manufacturing thereof according to one embodiment of present invention. More specifically, FIG. 7 illustrates a semiconductor structure 07 and one embodiment of the method includes, after forming buried power rails 611, 621, and 631, forming transistors such as NFETs and PFETs using the plurality of sets of fins by forming gates (not shown) and source/drain regions 711, forming one or more via-to-BPR contact (VBPR) 712, and forming source/drain contact layer 720 which may be a middle-of-line (MOL) layer. One or more back-end-of-line (BEOL) layers such as BEOL layers 730/740 and 750/760 may be subsequently formed on top of MOL layer 720.

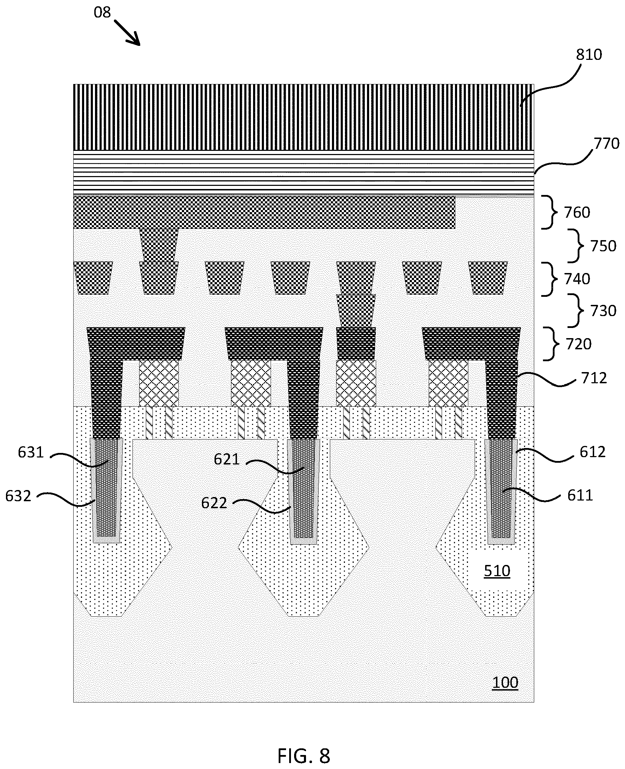

FIG. 8 is a demonstrative illustration of cross-sectional view of a semiconductor structure during a process of a method of manufacturing thereof according to one embodiment of present invention. More specifically, FIG. 8 illustrates a semiconductor structure 08 and one embodiment of the method includes forming additional BEOL layers 770 on top of BEOL layer 760, and subsequently wafer bonding a carrier wafer 810 on top of BEOL layers 770. Carrier wafer 810 may be bonded to semiconductor structure 08, for the ease of handling, such that semiconductor substrate 100 may be flipped upside down for further processing from the bottom of semiconductor substrate 100.

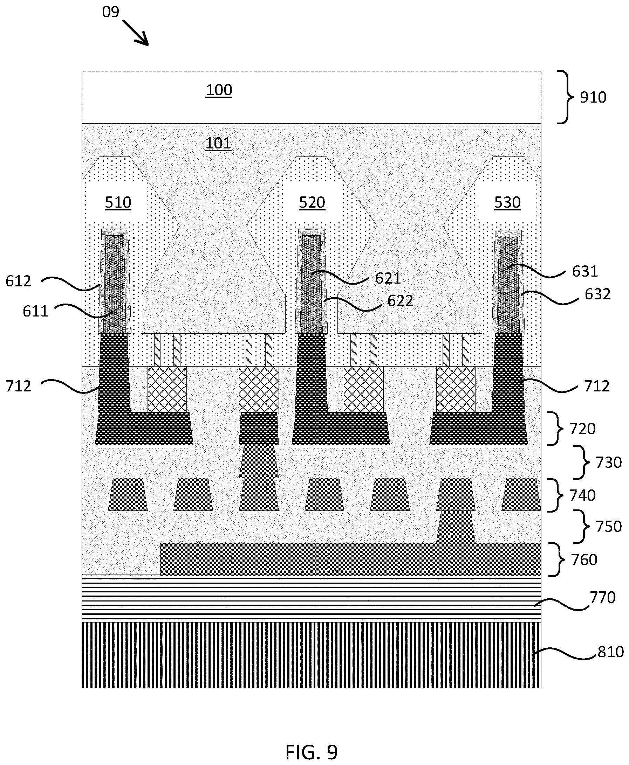

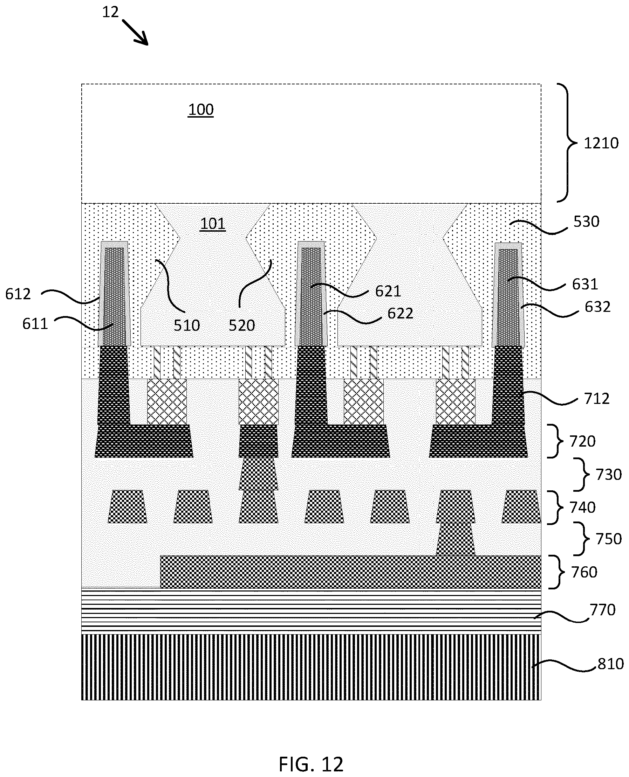

FIG. 9 is a demonstrative illustration of cross-sectional view of a semiconductor structure during a process of a method of manufacturing thereof according to one embodiment of present invention. More specifically, FIG. 9 illustrates a semiconductor structure 09 which is an upside-down flipped semiconductor structure 08 illustrated in FIG. 8. After flipping the semiconductor structure 08, one embodiment of the method includes thinning down, such as through grinding, CMP, or other etching processes, semiconductor substrate 100 by a thickness 910 to create a substrate layer 101. In one embodiment as being illustrated in FIG. 9, the thinning down process may not expose a top surface of the enlarged deep STI regions 510, 520, and 530. However, embodiment of present invention may include thinning down semiconductor substrate 100 to expose a top surface of or even into the enlarged deep STI regions 510, 520, and 530, as being described below in more details with reference to FIG. 12.

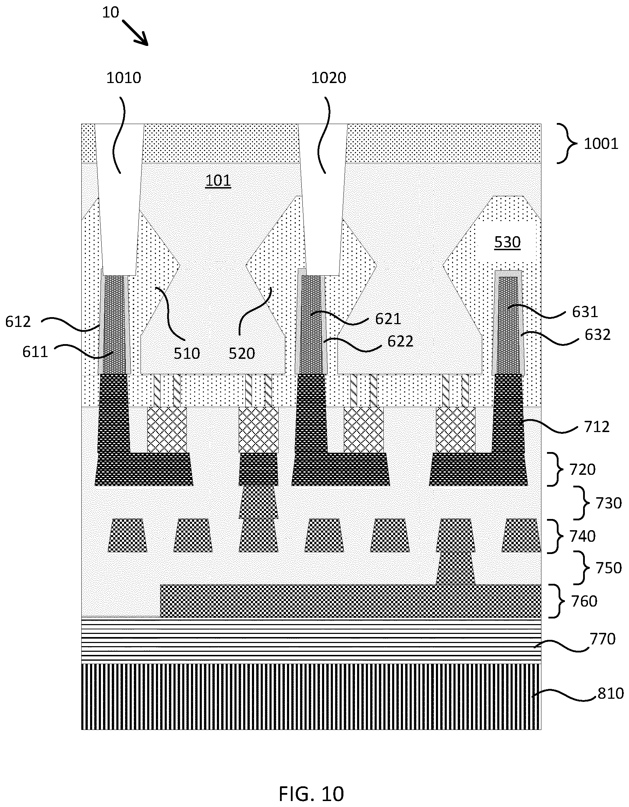

FIG. 10 is a demonstrative illustration of cross-sectional view of a semiconductor structure during a process of a method of manufacturing thereof according to one embodiment of present invention. More specifically, FIG. 10 illustrates a semiconductor structure 10 and one embodiment of the method includes depositing an inter-level dielectric (ILD) layer 1001 on top of the thinned down semiconductor substrate otherwise referred to herein as substrate layer 101. The embodiment then includes performing a lithographic patterning process to create openings such as openings 1010 and 1020 for forming through-silicon-vias (TSVs). TSVs may have different sizes in diameter and in one embodiment the diameter of TSVs may be in the range of 15 to 120 nanometers. Such TSVs may be referred to as nano TSVs (nTSVs). Embodiments of present invention may create openings 1010 and 1020 for forming TSVs in general and in one embodiment for forming nTSVs.

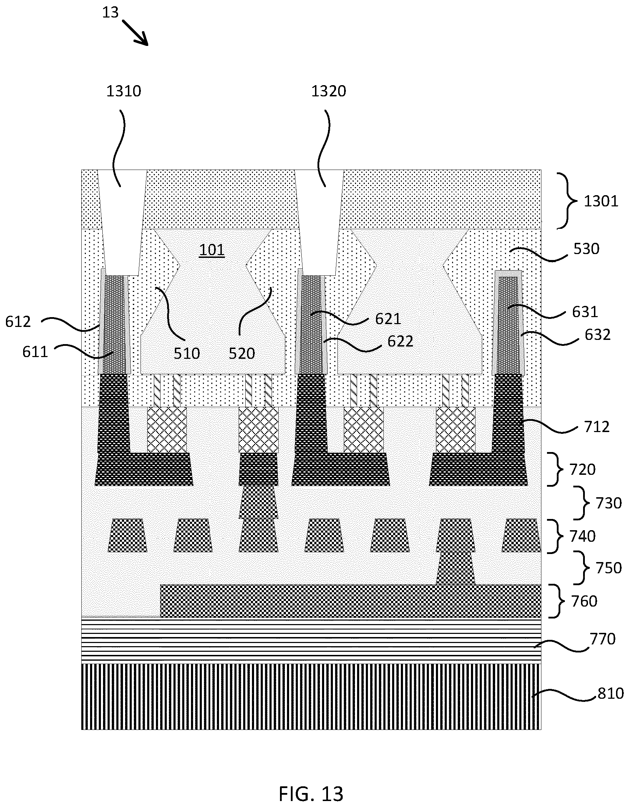

According to one embodiment of present invention, at least a bottom portion and a lower portion of openings 1010 and 1020 may be created entirely inside enlarged deep STI regions 510 and 520. However, embodiments of present invention are not limited in this aspect and in one embodiment, as being described below in more details with reference to FIG. 13, sidewalls of openings 1310 and 1320 may be entirely surrounded by the enlarged deep STI regions 510 and 520. In FIG. 10, as a non-limiting example, it is assumed that no opening (for forming TSV) is created in enlarged deep STI region 530.

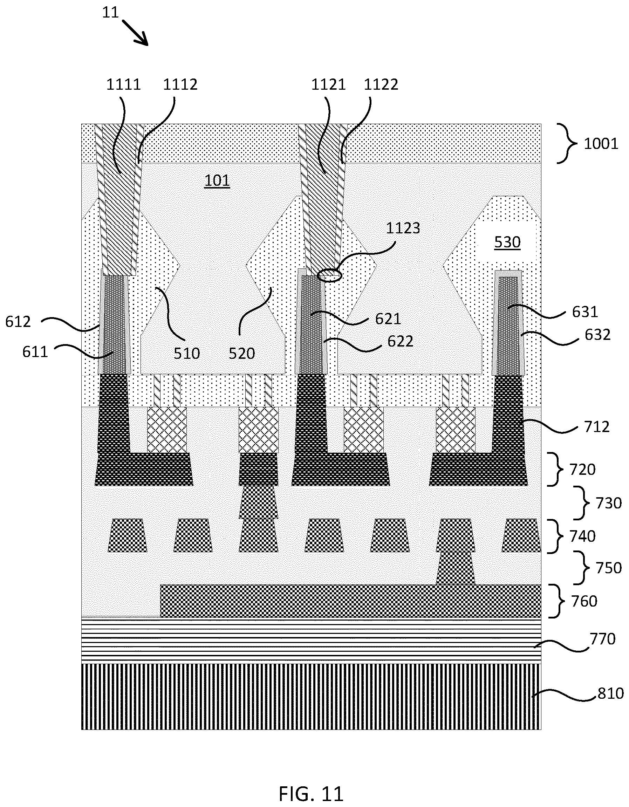

FIG. 11 is a demonstrative illustration of cross-sectional view of a semiconductor structure during a process of a method of manufacturing thereof according to one embodiment of present invention. More specifically, FIG. 11 illustrates a semiconductor structure 11 and one embodiment of the method includes forming liners 1112 and 1122 of dielectric material, such as SiN, lining openings 1010 and 1020. At the bottom of openings 1010 and 1020, horizontal portions of the liner material of liner 1112 and 1122 may be subsequently removed by an anisotropic etch to expose a bottom portion of BPR 611 and BPR 621 for contact purpose. Conductive material such as, for example, W, Co, Ru, or Cu may then be used to fill openings 1010 and 1020 to form TSVs and more particularly nTSVs 1111 and 1121. A bottom portion of nTSVs 1111 and 1112 contacts directly, at least partially, a bottom portion of BPR 612 and BPR 622.

Here it is to be noted that because at least a bottom portion of openings 1010 and 1020 are created entirely inside enlarged deep STI regions 510 and 520, a misalignment between, for example, BPR 621 and nTSV 1121 may cause a part 1123 of the bottom portion of nTSV 1121 to be exposed to enlarged deep STI region 520. Since enlarged deep STI region 520 is made of dielectric material such as flowable oxide, the misaligned part 1123 of the bottom portion of nTSV 1121 is still isolated from substrate layer 101.

FIG. 12 is a demonstrative illustration of cross-sectional view of a semiconductor structure during a process of a method of manufacturing thereof according to another embodiment of present invention. More specifically, FIG. 12 illustrates a semiconductor structure 12 following the step illustrated in FIG. 8. More particularly, one embodiment of the method includes flipping the semiconductor structure 08 in FIG. 08 upside down and performing a thinning process to semiconductor substrate 100 to remove a thickness 1210 thereof, which is relatively thicker than that of thickness 910 illustrated in FIG. 9, resulting in a thinner substrate layer 101. The removal of the thickness 1210 of semiconductor substrate 100 ensures that nTSVs formed in subsequent process steps to contact the BPRs are entirely surrounded by enlarged deep STI regions that are embedded in substrate layer 101.

FIG. 13 is a demonstrative illustration of cross-sectional view of a semiconductor structure during a process of a method of manufacturing thereof according to one embodiment of present invention. More specifically, FIG. 13 illustrates a semiconductor structure 13 and one embodiment of the method includes forming an ILD layer 1301 on top of substrate layer 101, and lithographically patterning one or more openings 1310 and 1320 for forming TSVs such as nTSVs. It is to be noted here that openings 1310 and 1320, at least for the portions that are inside substrate layer 101, are entirely surrounded by enlarged deep STI regions 510 and 520.

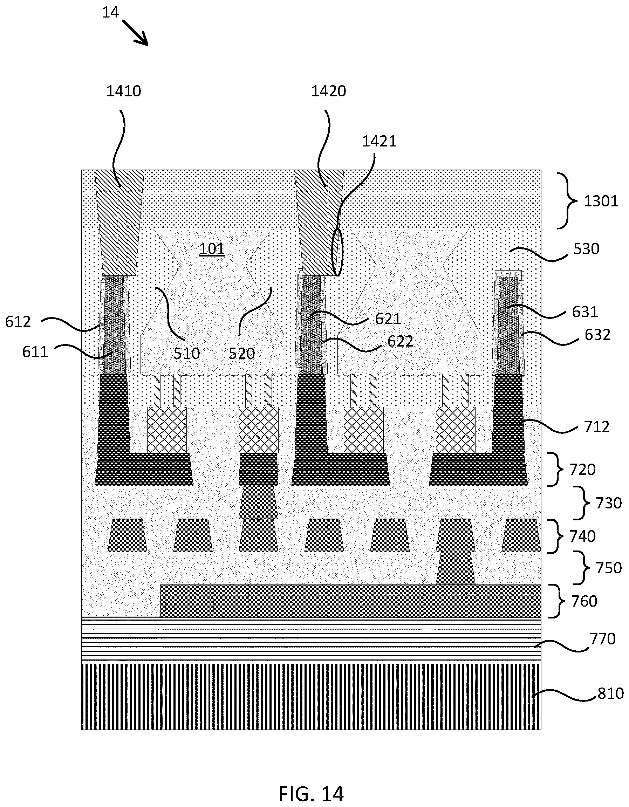

FIG. 14 is a demonstrative illustration of cross-sectional view of a semiconductor structure during a process of a method of manufacturing thereof according to one embodiment of present invention. More specifically, FIG. 14 illustrates a semiconductor structure 14 and one embodiment of the method includes performing metallization by filling openings 1310 and 1320 with one or more conductive materials such as, W, Co, Ru, and/or Cu, to form TSVs such as nTSVs 1410 and 1420. Contrast to nTSVs 1111 and 1121 illustrated in FIG. 11, since openings 1310 and 1320 are embedded in substrate layer 101 but separated and isolated from substrate layer 101 by enlarged deep STI regions 510 and 520, no dielectric liner such as SiN liner is needed to prevent nTSVs 1410 and 1420 from contacting or shorting substrate layer 101. For example, according to embodiment of present invention, when nTSV 1420 is misaligned with BPR 621, as an illustrative example shown in FIG. 14, a bottom of nTSV 1420 is covered by enlarged deep STI region 520. In the meantime, since sidewalls 1421 of nTSV 1420 are fully surrounded by enlarged deep STI region 520 as well, they are prevented from shorting or contacting substrate layer 101.

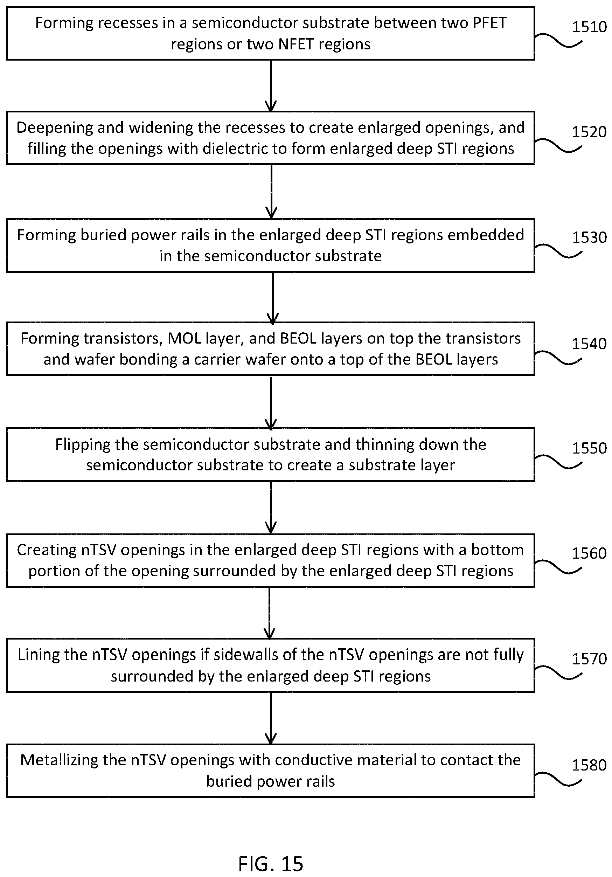

FIG. 15 is a demonstrative illustration of a flow-chart of a method of manufacturing a semiconductor structure according to embodiments of present invention. The embodiment includes (1510) forming first recesses in a semiconductor substrate between semiconductor device regions such as between two NFET regions or between two PFET regions; (1520) deepening and widening the first recesses to create enlarged openings and subsequently filling the enlarged openings with a dielectric material to form enlarged deep STI regions; (1530) forming buried power rails in the enlarged deep STI regions embedded in the semiconductor substrate; and (1540) forming transistors such as NFETs and PFETs and associated MOL layer and BEOL layers on top the transistors and wafer bonding a carrier wafer onto a top of the BEOL layers.

Embodiments of present invention further include (1550) flipping the semiconductor substrate upside down and thinning down a thickness of the semiconductor substrate to create a substrate layer with the thinning process, in one embodiment, exposing the enlarged deep STI regions; (1560) creating nano through-silicon-via (nTSV) openings in the enlarged deep STI regions with at least a bottom portion of the openings being surrounded by the enlarged deep STI regions. This nTSV creation process may be made by first depositing an inter-level-dielectric (ILD) layer on top of the substrate layer, planarizing the ILD layer, and patterning the nTSV openings through a lithographic patterning and etching process. In one embodiment, sidewalls of the nTSV openings are not fully surrounded by the enlarged deep STI regions, and the embodiment may include (1570) lining the nTSV openings with a dielectric liner. Embodiments of present invention may further include (1580) metallizing the nTSV openings with conductive material to contact the buried power rails.

Integrated circuit dies can be fabricated with various devices such as field-effect transistors, bipolar transistors metal-oxide-semiconductor transistors, diodes, capacitors, inductors, etc. An integrated circuit in accordance with the present invention can be employed in applications, hardware, and/or electronic systems. Suitable hardware and systems for implementing the invention may include, but are not limited to, personal computers, communication networks, electronic commerce systems, portable communications devices (e.g., cell phones), solid-state media storage devices, functional circuitry, etc. Systems and hardware incorporating such integrated circuits are considered part of the embodiments described herein. Given the teachings of the invention provided herein, one of ordinary skill in the art will be able to contemplate other implementations and applications of the techniques of the invention.

Although exemplary embodiments have been described herein with reference to the accompanying figures, it is to be understood that the invention is defined by the appended claims.

In some embodiments, the above-described techniques are used in connection with manufacture of semiconductor integrated circuit devices that illustratively include, by way of non-limiting example, CMOS devices, MOSFET devices, and/or FinFET devices, and/or other types of semiconductor integrated circuit devices that incorporate or otherwise utilize CMOS, MOSFET, and/or FinFET technology.

Accordingly, at least portions of one or more of the semiconductor structures described herein may be implemented in integrated circuits. The resulting integrated circuit chips may be distributed by the fabricator in raw wafer form (that is, as a single wafer that has multiple unpackaged chips), as a bare die, or in a packaged form. In the latter case the chip may be mounted in a single chip package (such as a plastic carrier, with leads that are affixed to a motherboard or other higher level carrier) or in a multichip package (such as a ceramic carrier that has either or both surface interconnections or buried interconnections). In any case the chip may then be integrated with other chips, discrete circuit elements, and/or other signal processing devices as part of either an intermediate product, such as a motherboard, or an end product. The end product may be any product that includes integrated circuit chips, ranging from toys and other low-end applications to advanced computer products having a display, a keyboard or other input device, and a central processor.

## Claims

1. A semiconductor structure comprising:
a substrate layer (101); and
a buried power rail (BPR) (611, 621) embedded in a deep shallow-trench-isolation (STI) region (510, 520, 530) inside the substrate layer,
wherein the BPR is isolated from the substrate layer by the deep STI region,
wherein the deep STI region has a first width at near a top thereof and a second width at near a middle portion thereof, wherein the second width being larger than the first width.

2. The semiconductor structure of claim 1, further comprising a nano through-silicon via (nTSV), a bottom portion of the nTSV contacting a bottom portion of the BPR, wherein the bottom portion of the nTSV is fully surrounded by the deep STI region.

3. The semiconductor structure of claim 2, wherein the nTSV is embedded in the substrate layer, and sidewalls of the nTSV are fully surrounded by and isolated from the substrate layer by the deep STI region.

4. The semiconductor structure of claim 2, wherein the nTSV comprises a conductive material that is in direct contact with the deep STI region at sidewalls of the nTSV.

5. The semiconductor structure of claim 2, wherein the nTSV is misaligned with the BPR, a first part of the bottom portion of the nTSV contacts the bottom portion of the BPR, and a second part of the bottom portion of the nTSV is covered by the deep STI region.

6. A method of forming a semiconductor structure comprising:
providing a semiconductor substrate (101);
forming first recesses in the semiconductor substrate;
deepening and laterally widening the first recesses to form deep STI regions (510, 520, 530); filling the deep STI regions with a dielectric material; and
forming at least one buried power rail (BPR) (611, 621) inside the dielectric material in the deep STI regions.

7. The method of claim 6, further comprising flipping the semiconductor substrate upside down and forming a nano through-silicon via (nTSV) through at least a portion of the semiconductor substrate, the nTSV contacting the at least one BPR.

8. The method of claim 7, wherein forming the nTSV further comprises thinning down the semiconductor substrate to create a substrate layer and depositing an inter-level-dielectric (ILD) layer on top of the substrate layer.

9. The method of claim 8, wherein forming the nTSV further comprising forming an nTSV opening through the ILD layer and the substrate layer to expose a bottom portion of the at least one BPR, via a patterning process, and filling the nTSV opening with one or more conductive materials to form the nTSV.

10. The method of claim 7, wherein laterally widening the first recesses comprises wet etching the first recesses to form the deep STI regions that have a sigma shape or a hexagon shape, and that have a first width at near a top thereof and a second width at near a middle portion thereof with the second width being larger than the first width.

11. The method of claim 7, further comprising, before forming the first recesses in the semiconductor substrate, forming a plurality of fin-sets on top of the semiconductor substrate including fin-sets for p-type field-effect-transistors (FETs) and fin-sets for n-type FETs, wherein the first recesses are formed between two fin-sets for a same type of FET.

12. The method of claim 11, further comprising forming the p-type FETs and the n-type FETs and forming a via-to-BPR contact to connecting the at least one BPR to at least one of the p-type FETs and the n-type FETs.

13. The method of claim 12, further comprising forming a middle-of-line (MOL) layer over the p-type and n-type FETs, back-end-of-line (BEOL) layers over the MOL layer, and wafer bonding a carrier wafer onto a top of the BEOL layers.

14. The semiconductor structure of claim 1, wherein a plurality of buried power rails (BPRs) are embedded in a plurality of lateral deep shallow-trench-isolation (STI) regions inside the substrate layer, and wherein the plurality of BPRs is isolated from the substrate layer, respectively, by the plurality of laterally deep STI regions.

15. The semiconductor structure of claim 14, wherein the laterally deep STI regions have a first width at near a top thereof and a second width at near a middle portion thereof, wherein the second width being larger than the first width.

## Patentansprüche

1. Halbleiterstruktur, umfassend:
eine Substratschicht (101); und
eine vergrabene Stromschiene (Buried Power Rail, BPR) (611, 621), eingebettet in eine tiefe Zone flacher Grabenisolierung (Shallow Trench Isolation, STI) (510, 520, 530) innerhalb der Substratschicht,
wobei die BPR durch die tiefe STI-Zone von der Substratschicht isoliert ist,
wobei die tiefe STI-Zone eine erste Breite in der Nähe einer Oberseite davon und eine zweite Breite in der Nähe eines mittleren Abschnitts davon aufweist, wobei die zweite Breite größer als die erste Breite ist.

2. Halbleiterstruktur nach Anspruch 1, welche ferner eine Nano-Durchkontaktierung durch Silicium (nano Through Silicon Via, nTSV) umfasst, wobei ein unterer Abschnitt der nTSV einen unteren Abschnitt der BPR kontaktiert, wobei der untere Abschnitt der nTSV vollständig von der tiefen STI-Zone umgeben ist.

3. Halbleiterstruktur nach Anspruch 2, wobei die nTSV in die Substratschicht eingebettet ist und Seitenwände der nTSV vollständig von der Substratschicht umgeben und durch die tiefe STI-Zone von dieser isoliert sind.

4. Halbleiterstruktur nach Anspruch 2, wobei die nTSV ein leitfähiges Material umfasst, welches an Seitenwänden der nTSV in direktem Kontakt mit der tiefen STI-Zone steht.

5. Halbleiterstruktur nach Anspruch 2, wobei die nTSV nicht mit der BPR in Ausrichtung steht, ein erster Teil des unteren Abschnitts der nTSV den unteren Abschnitt der BPR kontaktiert und ein zweiter Teil des unteren Abschnitts der nTSV von der tiefen STI-Zone bedeckt ist.

6. Verfahren zum Bilden einer Halbleiterstruktur, umfassend:
Bereitstellen eines Halbleitersubstrats (101);
Bilden erster Aussparungen in dem Halbleitersubstrat;
Vertiefen und seitliches Verbreitern der ersten Aussparungen, um tiefe STI-Zonen (510, 520, 530) zu bilden; Füllen der tiefen STI-Zonen mit einem dielektrischen Material; und
Bilden mindestens einer vergrabenen Stromschiene (BPR) (611, 621) innerhalb des dielektrischen Materials in den tiefen STI-Zonen.

7. Verfahren nach Anspruch 6, ferner umfassend Umdrehen des Halbleitersubstrats und Bilden einer Nano-Durchkontaktierung durch Silicium (nTSV) durch zumindest einen Abschnitt des Halbleitersubstrats, wobei die nTSV die mindestens eine BPR kontaktiert.

8. Verfahren nach Anspruch 7, wobei das Bilden der nTSV ferner Dünnen des Halbleitersubstrats, um eine Substratschicht zu erzeugen, und Abscheiden einer Schicht eines Zwischenschichtdielektrikums (Inter-Level-Dielectric, ILD) oben auf der Substratschicht umfasst.

9. Verfahren nach Anspruch 8, wobei das Bilden der nTSV ferner Bilden einer nTSV-Öffnung durch die ILD-Schicht und die Substratschicht, um einen unteren Abschnitt der mindestens einen BPR freizulegen, über einen Strukturierungsprozess und Füllen der nTSV-Öffnung mit einem oder mehreren leitfähigen Materialien zum Bilden der nTSV umfasst.

10. Verfahren nach Anspruch 7, wobei das seitliche Verbreitern der ersten Aussparungen Nassätzen der ersten Aussparungen umfasst, um die tiefen STI-Zonen zu bilden, welche eine Sigma-Form oder eine Sechseckform aufweisen und welche eine erste Breite in der Nähe einer Oberseite davon und eine zweite Breite in der Nähe eines mittleren Abschnitts davon aufweisen, wobei die zweite Breite größer als die erste Breite ist.

11. Verfahren nach Anspruch 7, ferner umfassend Bilden einer Mehrzahl von Finnengruppen oben auf dem Halbleitersubstrat vor dem Bilden der ersten Aussparungen in dem Halbleitersubstrat, umfassend Finnengruppen für p-Feldeffekttransistoren (FETs) und Finnengruppen für n-FETs, wobei die ersten Aussparungen zwischen zwei Finnengruppen für einen gleichen FET-Typ gebildet werden.

12. Verfahren nach Anspruch 11, ferner umfassend Bilden der p-FETs und der n-FETs und Bilden eines Durchkontaktierung-zu-BPR-Kontakts, um die mindestens eine BPR mit mindestens einem der p-FETs und der n-FETs zu verbinden.

13. Verfahren nach Anspruch 12, ferner umfassend Bilden einer Middle-of-Line-Schicht (MOL-Schicht) über den p-FETs und n-FETs, von Back-End-of-Line-Schichten (BEOL-Schichten) über der MOL-Schicht und Wafer-Bonding eines Träger-Wafers auf eine Oberseite der BEOL-Schichten.

14. Halbleiterstruktur nach Anspruch 1, wobei eine Mehrzahl von vergrabenen Stromschienen (BPRs) in eine Mehrzahl von lateralen tiefen Zonen flacher Grabenisolierungen (STI-Zonen) innerhalb der Substratschicht eingebettet sind und wobei die Mehrzahl von BPRs entsprechend durch die Mehrzahl von lateral tiefen STI-Zonen von der Substratschicht isoliert sind.

15. Halbleiterstruktur nach Anspruch 14, wobei die lateral tiefen STI-Zonen eine erste Breite in der Nähe einer Oberseite davon und eine zweite Breite in der Nähe eines mittleren Abschnitts davon aufweisen, wobei die zweite Breite größer als die erste Breite ist.

## Revendications

1. Structure semi-conductrice comprenant :
une couche de substrat (101) ; et
un rail d'alimentation enfoui (BPR) (611, 621) intégré dans une région (510, 520, 530) profonde d'isolation de tranchée peu profonde (STI) à l'intérieur de la couche de substrat,
dans laquelle le BPR est isolé de la couche de substrat par la région profonde de STI,
dans laquelle la région profonde de STI possède une première largeur près de sa partie supérieure et une seconde largeur près de sa partie centrale, où la seconde largeur est plus grande que la première largeur.

2. Structure semi-conductrice selon la revendication 1, comprenant en outre un nano-via traversant le silicium (nTSV), une partie inférieure du nTSV étant en contact avec une partie inférieure du BPR, où la partie inférieure du nTSV est totalement entourée et isolée par la région profonde de STI.

3. Structure semi-conductrice selon la revendication 2, dans laquelle le nTSV est intégrée dans la couche de substrat, et des parois latérales du nTSV sont totalement entourées et isolées de la couche de substrat par la région profonde de STI.

4. Structure semi-conductrice selon la revendication 2, dans laquelle le nTSV comprend une matière conductrice qui est en contact direct avec la région profonde de STI au niveau des parois latérales du nTSV.

5. Structure semi-conductrice selon la revendication 2, dans laquelle le nTSV est désalignée du BPR, une première partie de la partie inférieure du nTSV étant en contact avec la partie inférieure du BPR, et une seconde partie de la partie inférieure du nTSV est couverte par la région profonde de STI.

6. Procédé de formation d'une structure semi-conductrice comprenant :
la fourniture d'un substrat semi-conducteur (101) ;
la formation de premiers renfoncements dans le substrat semi-conducteur ;
l'approfondissement et l'élargissement latéral des premiers renfoncements pour former des régions profondes de STI (510, 520, 530) ; le remplissage des régions profondes de STI avec une matière diélectrique ; et
la formation d'au moins un rail d'alimentation enfoui (BPR) (611, 621) à l'intérieur de la matière diélectrique dans les régions profondes de STI.

7. Procédé selon la revendication 6, comprenant en outre la mise à l'envers du substrat semi-conducteur et la formation d'un nano-via traversant le silicium (nTSV) à travers au moins une partie du substrat semi-conducteur, le nTSV étant en contact avec l'au moins un BPR.

8. Procédé selon la revendication 7, dans lequel la formation du nTSV comprend en outre la réduction de la taille du substrat semi-conducteur pour créer une couche de substrat et le dépôt d'une couche diélectrique inter-niveau (ILD) sur la partie supérieure de la couche de substrat.

9. Procédé selon la revendication 8, dans lequel la formation du nTSV comprenant en outre la formation d'un orifice de nTSV à travers la couche ILD et la couche de substrat pour mettre à nu une partie inférieure de l'au moins un BPR, par un processus de modélisation, et le remplissage de l'orifice de nTSV avec une ou plusieurs matières conductrices pour former le nTSV.

10. Procédé selon la revendication 7, dans lequel l'élargissement latéral des premiers renfoncements comprend une gravure humide des premiers renfoncements pour former les régions profondes de STI qui ont une forme de sigma ou une forme hexagonale, et qui ont une première largeur près de leur partie supérieure et une seconde largeur près de leur partie centrale, avec la seconde largeur étant plus grande que la première largeur.

11. Procédé selon la revendication 7, comprenant en outre, avant la formation des premiers renfoncements dans le substrat semi-conducteur, la formation d'une pluralité d'ensembles d'ailettes sur la partie supérieure du substrat semi-conducteur incluant des ensembles d'ailettes pour des transistors à effet de champ de type p (FETs) et des ensembles d'ailettes pour des FETs de type n, où les premiers renfoncements sont formés entre deux ensembles d'ailettes pour un même type de FET.

12. Procédé selon la revendication 11, comprenant en outre la formation de FETs de type p et ensuite de FETs de type n et la formation d'un contact de via vers le BPR pour connecter l'au moins un BPR à au moins un des FETs de type p et ensuite des FETs de-type n.

13. Procédé selon la revendication 12, comprenant en outre la formation d'une couche de milieu de ligne (MOL) au-dessus des FETs de type p et de type n, de couches de fin de ligne (BEOL) au-dessus de la couche MOL, et la liaison de plaquette d'une plaquette porteuse sur une partie supérieure des couches BEOL.

14. Structure semi-conductrice selon la revendication 1, dans laquelle une pluralité de rails d'alimentation enfouis (BPRs) sont enfouis dans une pluralité de régions profondes d'isolation de tranchée peu profonde (STI) à l'intérieur de la couche de substrat, et où la pluralité des BPRs est isolée de la couche de substrat, respectivement, par la pluralité des régions profondes de STI.

15. Structure semi-conductrice selon la revendication 14, dans laquelle les régions latéralement profondes de STI ont une première largeur près de leur partie supérieure et une seconde largeur près de leur partie centrale, la seconde largeur étant plus grande que la première largeur.
